# EUROPEAN PATENT APPLICATION

(11) **EP 4 579 251 A1**
(43) Date of publication of application: **02.07.2025**
(21) Application number: 23866854.5
(22) Date of filing: 22.03.2023
(51) Int. Cl.: G01R 31/28, G11C 29/12, G06F 30/333

(54) **CHIP TEST METHOD AND APPARATUS, CHIP, AND COMPUTER READABLE STORAGE MEDIUM**

(30) Priority: 22.09.2022 CN 202211162084
(71) Applicant: Sanechips Technology Co., Ltd., Shenzhen, Guangdong 518055 (CN)
(72) Inventor: OUYANG, Keqing, Shenzhen, Guangdong 518055 (CN); PENG, Minqiang, Shenzhen, Guangdong 518055 (CN); ZHOU, Guohua, Shenzhen, Guangdong 518055 (CN); PAN, Feilong, Shenzhen, Guangdong 518055 (CN); CHEN, Lei, Shenzhen, Guangdong 518055 (CN)
(74) Representative: Chimini, Francesco
(86) International application number: PCT/CN2023/083191
(87) International publication number: WO 2024/060555

(57) **Abstract**

The application discloses a chip test method and apparatus, a chip and a computer readable storage medium. The method comprises: a main controller sends a test instruction to each sub-controller in a storage built-in self-test circuit; a test control circuit configures each sub-controller according to preset groups; each sub-controller in the preset groups is tested according to the test instruction; if the test result is that the preset groups do not meet a preset standard, the sub-controllers are re-grouped on the basis of the test result and iterative testing is performed until the iterative test result is that the current groups meet the preset standard.

## Description

### Related Application

The present disclosure claims priority to Chinese Patent Application No. 202211162084.X, filed on September 22, 2022, which is incorporated herein by reference in its entirety.

### Technical Field

Embodiments of the present disclosure relate to the field of integrated circuit test technologies, and in particular, to a chip test method and apparatus, a chip, and a computer readable storage medium.

### Background

Inserting a Memory Built-In Self-Test (MBIST) circuit into a chip to detect faults during a production process of a memory is currently a mainstream practice. During a test phase, by inputting test vectors, the MBIST circuit may generate pseudo-random test sequences and perform a response analysis on an output of the memory to determine whether there are any faults during the production of the memory.

At present, a method for generating MBIST test vectors mainly includes the following process: first, reading in an engineering file of the design, then configuring according to preset test groups, and finally generating an MBIST test vector corresponding to each test group. However, in an actual test process, due to issues such as power consumption during testing and voltage drop (IR_Drop), the preset test groups are often not optimal test groups, and iterations of grouping are required to be performed based on a test result, wherein each iteration of grouping requires regeneration of the MBIST test vectors according to the aforementioned process.

Nevertheless, since the generation of the test vectors requires a significant amount of time and effort, the efficiency of iteration through the above method is relatively low, which in turn results in a lower efficiency of actual testing.

### Summary

The embodiments of the present disclosure provide a chip test method and apparatus, a chip, and a computer readable storage medium, which may solve the technical problem of low iteration efficiency of MBIST test vectors.

In order to solve the technical problem, the embodiments of the present disclosure provide a chip test method. The chip test method includes:
sending, by a main controller, a test instruction to respective sub-controllers in a memory built-in self-test circuit;
configuring, by a test control circuit, the respective sub-controllers according to a preset group;
performing, by each sub-controller in the preset group, a test according to the test instruction; and
in a case where a test result indicates that the preset group does not comply with a preset standard, re-grouping the respective sub-controllers based on the test result and performing an iterative test until a test result of the iterative test indicates that a current group complies with the preset standard.

In order to solve the technical problem, the embodiments of the present disclosure further provide a chip test apparatus. The chip test apparatus includes:
a main body module, configured for a main controller to send a test instruction to respective sub-controllers in a memory built-in self-test circuit;
a configuring module, configured for a test control circuit to configure the respective sub-controllers according to a preset group;
a testing module, configured for each sub-controller in the preset group to perform a test according to the test instruction; and
an iteration module, configured to, in a case where a test result indicates that the preset group does not comply with a preset standard, re-group the respective sub-controllers based on the test result and perform an iterative test until a test result of the iterative test indicates that a current group complies with the preset standard.

In order to solve the technical problem, the embodiments of the present disclosure further provide a chip. The chip includes: a memory, a processor and a computer program stored on the memory and operable on the processor, wherein the computer program, when executed by the processor, implements the described chip test method.

In order to solve the technical problem, the embodiments of the present disclosure further provide a computer readable storage medium. The computer readable storage medium stores a computer program, and the computer program, when being executed by a processor, implements the described chip test method.

The embodiments of the present disclosure provide a chip test method and apparatus, a chip, and a computer readable storage medium, which address the technical problem of low iteration efficiency of MBIST test vectors in the related art. In the chip test method, a main controller first sends a test instruction to respective sub-controllers in a memory built-in self-test circuit; then, a test control circuit configures the respective sub-controllers according to a preset group; after that, each sub-controller in the preset group performs a test according to the test instruction; and in a case where a test result indicates that the preset group does not comply with a preset standard, the respective sub-controllers are re-grouped based on the test result and an iterative test is performed until a test result of the iterative test indicates that a current group complies with the preset standard.

Thus, in the embodiments of the present disclosure, when an iterative test needs to be performed, it is unnecessary to reconfigure, by the main controller, a MBIST test vector for each sub-controller in the new group determined by the re-grouping, it is only needed to determine, by the test control circuit, which sub-controllers receive the test instruction to perform the iteration test according to the new group. In other words, the MBIST test vector in the embodiments of the present disclosure only needs to be generated once, and as compared with the related art, this saves a lot of time required for repeatedly generating the test vector. In the embodiments of the present disclosure, when an iterative test is performed, the iterative test can be implemented only by configuring, by the test control circuit, the MBIST test vector to corresponding sub-controllers according to the group of the sub-controllers, so that update iteration of the MBIST test vector may be conveniently implemented, and iteration efficiency of the MBIST test vector may be significantly improved.

### Brief Description of the Drawings

To describe the technical solutions in the embodiments of the present disclosure or in the related art more clearly, the accompanying drawings required for describing the embodiments or the related art are briefly introduced as follows. Apparently, the accompanying drawings in the following description show merely a part of embodiments of the present disclosure, other drawings may also be acquired according to these drawings without creative efforts.
Fig. 1 is a schematic flowchart of a chip test method according to an embodiment of the present disclosure;
Fig. 2 is a schematic diagram of an application scenario in which a chip test method according to an embodiment of the present disclosure is applied;
Fig. 3 is a schematic diagram of test grouping involved in a chip test method according to an embodiment of the present disclosure;
Fig. 4 is a schematic structural diagram of a chip test apparatus according to an embodiment of the present disclosure; and
Fig. 5 is a schematic diagram of the hardware structure of a chip according to an embodiment of the present disclosure.

### Detailed Description of the Embodiments

In the following description, specific details such as particular system structures, technologies, etc., are provided for illustrative purposes rather than for the purpose of limitation, in order to thoroughly understand the embodiments of the present disclosure. However, those having ordinary skill in the art should be clear that the embodiments of the present disclosure can also be implemented without these specific details in other embodiments. In other cases, details of well-known systems, devices, circuits, and methods are omitted to avoid unnecessary details from hindering the description of the embodiments of the present disclosure.

It should be noted that although a logical sequence is shown in the flowchart, in some cases, the operations shown or described can be executed in a different order from that in the flowchart. The terms "first", "second", etc., in the specification and claims and the above drawings are used to distinguish similar objects and are not necessarily used to describe a specific order or sequence.

It should also be understood that the phrases "an embodiment" or "some embodiments" etc., described in the specification of the present disclosure mean that one or more embodiments of the present disclosure include the specific features, structures, or characteristics described in conjunction with that embodiment. Therefore, phrases such as "in an embodiment", "in some embodiments", "in other embodiments", and "in still other embodiments" etc., appearing in different places in this specification do not necessarily refer to the same embodiment but mean "one or more but not all embodiments", unless otherwise specifically emphasized. The terms "comprising", "including", "having", and their variations mean "including but not limited to", unless otherwise specifically emphasized.

Inserting a Memory Built-In Self-Test (MBIST) circuit into a chip to detect faults during a production process of a memory is currently a mainstream practice. During a test phase, by inputting test vectors, the MBIST circuit may generate pseudo-random test sequences and perform a response analysis on an output of the memory to determine whether there are any faults during the production of the memory.

At present, a method for generating MBIST test vectors mainly includes the following process: first, reading in an engineering file of the design, then configuring according to preset test groups, and finally generating an MBIST test vector corresponding to each test group. However, in an actual test process, due to issues such as power consumption during testing and voltage drop (IR_Drop), the preset test groups are often not optimal test groups, and iterations of grouping are required to be performed based on a test result, wherein each iteration of grouping requires regeneration of the MBIST test vectors according to the aforementioned process.

Nevertheless, since the generation of the test vectors requires a significant amount of time and effort, the efficiency of iteration through the above method is relatively low, which in turn results in a lower efficiency of actual testing.

Accordingly, the embodiments of the present disclosure provide a chip test method and apparatus, a device, and a computer readable storage medium, which address the technical problem of low iteration efficiency of MBIST test vectors in the related art. In the chip test method, a main controller first sends a test instruction to respective sub-controllers in a memory built-in self-test circuit; then, a test control circuit configures the respective sub-controllers according to a preset group; after that, each sub-controller in the preset group performs a test according to the test instruction; and in a case where a test result indicates that the preset group does not comply with a preset standard, the respective sub-controllers are re-grouped based on the test result and an iterative test is performed until a test result of the iterative test indicates that a current group complies with the preset standard. Thus, in the embodiments of the present disclosure, when an iterative test needs to be performed, it is unnecessary to reconfigure, by the main controller, a MBIST test vector for each sub-controller in the new group determined by the re-grouping, it is only needed to determine, by the test control circuit, which sub-controllers receive the test instruction to perform the iteration test according to the new group. In other words, the MBIST test vector in the embodiments of the present disclosure only needs to be generated once, and as compared with the related art, this saves a lot of time required for repeatedly generating the test vector. In the embodiments of the present disclosure, when an iterative test is performed, the iterative test can be implemented only by configuring, by the test control circuit, the MBIST test vector to corresponding sub-controllers according to the group of the sub-controllers, so that update iteration of the MBIST test vector may be conveniently implemented, and iteration efficiency of the MBIST test vector may be significantly improved.

The embodiments of the present disclosure provide a chip test method and apparatus, a device, and a computer readable storage medium, which are specifically described through the following embodiments. The chip test method in the embodiments of the present disclosure is described first.

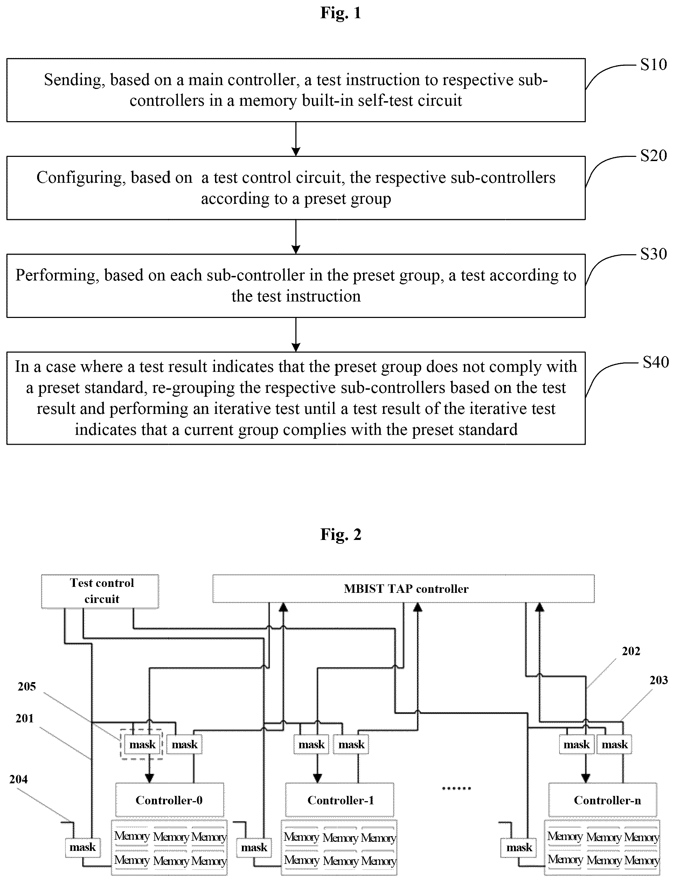

As shown in Fig. 1, Fig. 1 is a schematic flowchart of a chip test method according to an embodiment of the present disclosure. The chip test method may be applied to chip test equipment. As shown in Fig. 1, the chip test method provided in the embodiment includes operations S10 to S40.

In operation S10: a main controller sends a test instruction to respective sub-controllers in a memory built-in self-test circuit.

The embodiment is applied to a chip test environment, which may be understood in combination with Fig. 2. Fig. 2 is a schematic diagram of an application scenario according to the embodiment. In this embodiment, an MBIST circuit (i.e., a memory built-in self-test circuit), a test control circuit, and a plurality of mask modules 205 form a circuit combination for performing MBIST test on the chip. This circuit combination is integrated in advance within the chip to be tested. The main purpose of the MBIST circuit is to detect whether there are any faults in the memories within the chip. After the MBIST circuit is input with test vectors, the MBIST circuit generates pseudo-random sequences to test the memories and collects the outputs for comparison to determine whether there are any faults in the memories. In this embodiment, the MBIST circuit includes a main controller, namely the MBIST TAP (Test Access Port) controller shown in Fig. 2, and a plurality of sub-controllers (namely controllers-0, controller-1, ..., controller-n shown in Fig. 2) connected to the MBIST TAP controller. Each controller (specifically referring to the sub-controller in the embodiments) can be controlled independently and in parallel. In operation S10, the main controller sends the same test instruction to all of the plurality of sub-controllers within the memory built-in self-test circuit. The downward arrows 202 shown in Fig. 2, connecting the MBIST TAP controller to respective sub-controllers, represent test enable signals sent by the main controller to the respective sub-controllers. The upward arrows 203 in Fig. 2 represent test result feedback signals sent by the respective sub-controllers to the main controller. In Fig. 2, the reference number 204 represents test clock signals provided inside the chip to respective memories.

In operation S20, the test control circuit configures the respective sub-controllers according to a preset group.

Although in operation S10 of this embodiment, the main controller sends the test instruction to all the sub-controllers, it does not mean that all sub-controllers can directly receive the test instruction and perform an MBIST test on the corresponding memories in the chip. As shown in Fig. 2, there are mask modules that are able to be independently controlled on signal transmission paths between the main controller and the respective sub-controllers, and respective mask modules are connected to the test control circuit. The lines marked by the reference number 201 in Fig. 2 represent the connection relationship between the test control circuit and the respective mask modules. The test control circuit may control which sub-controllers are able to receive the test instruction sent by the main controller and which sub-controllers are not able to receive the test instruction sent by the main controller.

When the chip is in an MBIST test mode, power consumption of the chip is often greater than that in a working mode of the chip. The heat generation problem caused by excessive power consumption can affect the yield of the chip. To avoid affecting the yield, group-based parallel testing is a commonly used test method. Therefore, in this embodiment, a method of group-based parallel testing for the memories of the chip through the respective sub-controllers is implemented based on the test control circuit. That is, the basis for the test control circuit to configure the respective sub-controllers is whether each of the respective sub-controllers belongs to the test group. The preset group is a test group consisting of sub-controllers for a first round of testing in the MBIST test and may be obtained by technical personal in advance by grouping the respective sub-controllers in the memory built-in self-test circuit. The preset group includes sub-controllers that need to receive the test instruction in a current round of testing. Therefore, the test control circuit will set each mask module between each sub-controller in the preset group and the main controller to a conductive state, enabling the each sub-controller in the preset group to successfully receive the test instruction sent by the main controller. At the same time, the test control circuit will set each mask module between each sub-controller not belonging to the preset group and the main controller to a cut-off state, preventing each sub-controller not belonging the preset group from receiving the test instruction sent by the main controller, achieving the function of skipping the test for these sub-controllers, and avoiding the impact of these sub-controllers not belonging to the test group on the test result of the test group.

In operation S30, each sub-controller in the preset group performs a test according to the test instruction.

Since the signal transmission paths between the sub-controllers within the preset group and the main controller are not cut off, each sub-controller in the preset group is able to successfully receive the test instruction sent by the main controller, and then conduct a test based on the test instruction and feed back a test result to the main controller. After receiving the test result from the each sub-controller in the preset group, the main controller is able to analyze data including, for example, at least one of power consumption, test time, and voltage drop (IR_Drop) based on the test result fed back by all the sub-controllers in the preset group, and then determine whether the test group is appropriate based on whether the data meet a preset standard.

In operation S40, in a case where a test result indicates that the preset group does not comply with a preset standard, the respective sub-controllers are re-grouped based on the test result and an iterative test is performed until a test result of the iterative test indicates that a current group complies with the preset standard.

If the preset group does not comply with the preset standard, then it is necessary to re-group the respective sub-controllers based on the test result and conduct the MBIST test again based on the new group of sub-controllers according to the test instruction continuously sent by the main controller. In such a case, it is necessary to perform operation S20 and S30 again, simply replacing the preset group with the new group. The new group for conducting the MBIST test again may include at least one of the sub-controllers from the preset group or may not include any sub-controller from the preset group. The specific grouping method may be determined based on the actual situation, or a set of rules may be established for the chip test equipment to select the sub-controllers of the new group automatically. For example, in a case where the sub-controllers in the preset group are used to perform a first round of testing for the corresponding memories in the chip, then other sub-controllers not belonging to the preset group may be used to perform a second round of testing for the corresponding memories in the chip. The specific grouping manner is not limited in the embodiments of the present disclosure.

The embodiments of the present disclosure provide a chip test method that improves the architecture of the MBIST circuit. By adding independently controllable mask logic to each parallel-controlled controller, the test instruction sent by the MBIST main TAP controller may be shielded. The test clock of each controller, the test enable signal sent by the MBIST main TAP, and the test result feedback signal sent to the MBIST main TAP may all be shielded by signals from the test control circuit, thereby skipping the test. When generating the MBIST test vector, the MBIST main TAP controller will send the test instruction to all controllers in a main part of the vector, and whether each controller will be shielded will be determined based on the configuration part. Therefore, when performing vector iteration, it is only necessary to modify the configuration part of the configuration. Considering that the scale of the chip is getting larger and larger, due to issues such as test power consumption and IR Drop, it is necessary to continuously adjust and change the test grouping, and the MBIST test vector also needs to be updated and iterated with the change of the test grouping. The solution described in the embodiments may conveniently achieve the update and iteration of the MBIST test vector and may significantly improve the iteration efficiency of the MBIST test vector.

When an iterative test needs to be performed, it is unnecessary to reconfigure, by the main controller, a MBIST test vector for each sub-controller in the new group determined by the re-grouping, it is only needed to determine, by the test control circuit, which sub-controllers receive the test instruction to perform the iteration test according to the new group. In other words, the MBIST test vector in the embodiments of the present disclosure only needs to be generated once, and as compared with the related art, this saves a lot of time required for repeatedly generating the test vector. In the embodiments of the present disclosure, when an iterative test is performed, the iterative test can be implemented only by configuring, by the test control circuit, the MBIST test vector to corresponding sub-controllers according to the group of the sub-controllers, so that update iteration of the MBIST test vector may be conveniently implemented, and iteration efficiency of the MBIST test vector may be significantly improved.

In some feasible embodiments, before operation S10, the chip test method may further include, but is not limited to, the following operations A and B.

In operation A, the main controller reads a preset engineering file.

In operation B, the main controller performs configuration according to the engineering file so as to generate a test vector, wherein the test vector includes the test instruction.

In this embodiment, a generation manner of the test vector is consistent with a general MBIST test vector generation process: that is, the main controller reads an engineering file of design, and performs configuration according to the engineering file so as to generate the corresponding test vector. The difference lies in that, in this embodiment, the MBIST TAP controller sends a test instruction to all the sub-controllers, that is, the distribution of the test vector is performed towards all the sub-controllers.

In some feasible embodiments, operation S20 may include, but is not limited to, the following operation A20.

In operation A20, the test control circuit shields the test instruction sent by the main controller towards each sub-controller not belonging to the preset group.

It should be noted that Fig. 2 merely illustrates an application scenario provided in this embodiment, and does not mean that this embodiment has to use additional mask modules to support the test control circuit in configuring the sub-controllers in the MBIST circuit. The test control circuit may alternatively directly shield the test instruction sent by the main controller towards sub-controllers not belonging to the preset group by sending a shield signal or an interference signal.

In some feasible embodiments, at least one set of shielding logic circuit is disposed between the main controller and each of the respective sub-controllers. Operation S20 may include, but is not limited to, the following operations B20 and B21.

In operation B20, the test control circuit turns off the shielding logic circuit between the each sub-controller in the preset group and the main controller.

In operation B21, the test control circuit turns on the shielding logic circuit between each sub-controller not belonging to the preset group and the main controller.

t is understandable that although the mask modules shown in Fig. 2 may be considered as the shielding logic circuits set between the main controller and the respective sub-controllers, "mask" is a more general term, and there may be many specific ways to implement the shielding logic circuits. In this embodiment, the setting of at least one set of shielding logic circuit between the main controller and each of the respective sub-controllers refers to a set of shielding logic circuit used to shield the test instruction sent by the main controller towards the sub-controller. As can be seen from Fig. 2, in this embodiment, another set of shielding logic circuit may be disposed on a signal transmission path by which each sub-controller feeds back signals to the main controller, and still another set of shielding logic circuit may be disposed between a test clock signal supplied inside the chip and each corresponding memory. When it is necessary to shield sub-controllers unrelated to the test, all signal interaction channels between the sub-controllers and external components may be closed, thereby effectively avoiding the impact of uncertain factors in the test process and ensuring the accuracy of the test result.

In some feasible embodiments, operation S30 may include, but is not limited to, the following operation S301.

In operation S301, each sub-controller in the preset group acquires the test vector according to the test instruction to perform the test.

The test instruction is a part of the test vector generated by the main controller. Sub-controllers that receive the test instruction may obtain the test vector for memory testing from the main controller based on this test instruction, and conduct the test on the corresponding memory in the chip based on the test vector in combination with the test clock signal.

In some feasible embodiments, after operation S30, the chip test method may further include, but is not limited to, the following operations S31 to S33.

In operation S31, the main controller acquires a test result of the each sub-controller in the preset group.

In operation S32, the main controller compares the test result with preset data to acquire a comparison result.

In operation S33, the main controller determines whether the preset group complies with the preset standard according to the comparison result.

The test result is obtained after the chip test equipment merges, via the main controller, test outcomes from all sub-controllers in the preset group. After the chip test equipment receives, via the main controller, all the test outcomes feedback from the sub-controllers within the preset group, the chip test equipment may analyze data such as power consumption, test time, and voltage drop (IR_Drop) based on these test outcomes, and then compares these data with the preset standard data. The comparison result indicates whether these data meet the standard. If the data meet the standard, it suggests that the preset group complies with the preset standard. If the data do not meet the standard, it indicates that the preset group does not comply with the preset standard, and iterative test is required.

In some feasible embodiments, the operation S40 of re-grouping the respective sub-controllers based on the test result and performing the iteration test includes the following operations S41 to S43.

In operation S41, the respective sub-controllers are re-grouped based on the test result.

In operation S42, the test control circuit configures the respective sub-controllers according to a new group determined by the re-grouping.

In operation S43, each sub-controller in the new group performs the iteration test according to the test instruction.

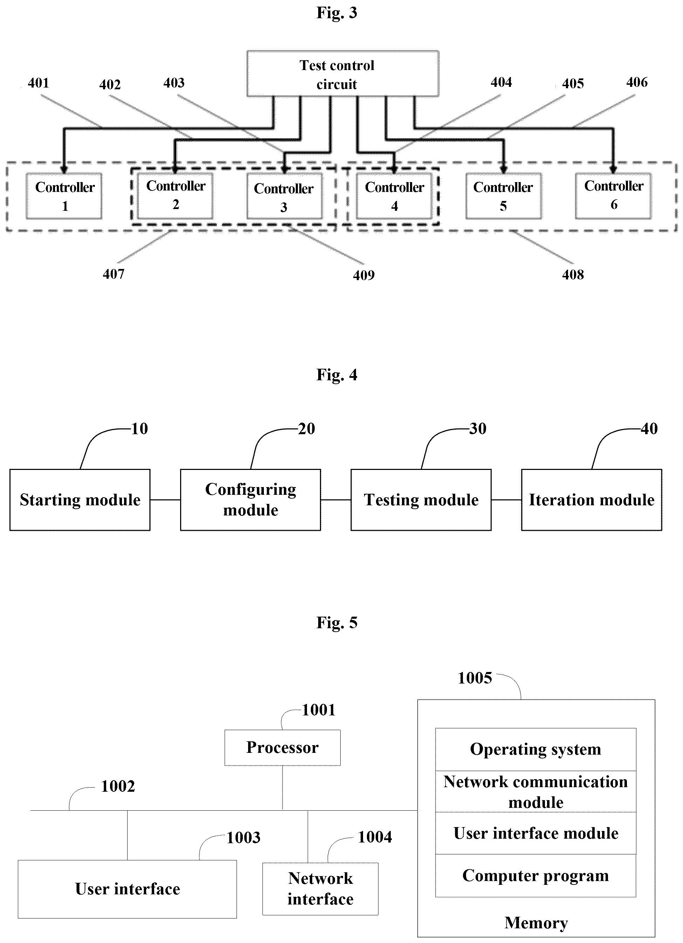

Exemplarily, this embodiment may be understood in conjunction with Figs. 2 and 3. Fig. 3 is a schematic diagram of test grouping provided in this embodiment. After the test begins, the MBIST main TAP will send a parallel test instruction to all controllers, meaning that test enable signals 202 and test clock signals 204 for all controllers will be in an enabled mode. At this point, a preliminary test group needs to be determined, and the preliminary test group may be determined according to a clock domain and distribution of memories within a chip. As shown in Fig. 3, a first preset group 407 includes Controller 1, Controller 2, and Controller 3, while a second preset group 408 includes Controller 4, Controller 5, and Controller 6. Then, according to the above preset groups, the test control circuit generates a configuration part of the test vector. For the preset group 407, in the configuration part, mask signals 404, 405, and 406 need to be delivered to Controller 4, Controller 5, and Controller 6 respectively through the test control circuit. In this way, when an Automatic Test Equipment (ATE) machine uses this test vector for testing, Controller 4, Controller 5, and Controller 6 will not enter the MBIST test mode, and only Controller 1, Controller 2, and Controller 3 will perform the MBIST test. The second preset group 408 is the opposite of the first preset group 407, which means that test needs to be performed for Controller 4, Controller 5, and Controller 6, so mask signals need to be sent to Controller 1, Controller 2, and Controller 3 through the test control circuit. When the ATE machine performs a test according to the second test vector, only Controller 4, Controller 5, and Controller 6 will be tested. It should be noted that a main part of the test vectors for the first preset group 407 and the second preset group 408 is exactly the same, with the difference lying only in the masking of different controllers in the configuration part. According to this embodiment, the ATE machine performs the test based on the test vectors for the first preset group 407 and the second preset group 408 and analyzes the test results, including data such as test power consumption, test time, and IR_Drop. The analysis shows that the initial groupings, i.e., the first preset group 407 and the second preset group 408 are not optimal groupings, requiring re-grouping and iterative testing of the vectors. A new group 409 determined by the re-grouping may include Controller 2, Controller 3, and Controller 4. The configuration part of the test vector for the new group 409 needs to be updated, and it is only needed to simply send the mask signals to Controller 1, Controller 5, and Controller 6 through the test control circuit. A main part of the vector remains unchanged. Then, the new test vector is handed over to the ATE to complete the vector iteration, without the need to re-generate the main part of the test vector again during the iteration process. After the ATE completes the test, the test result is analyzed to see if the test power consumption, the test time, and the IR_Drop meet the requirements. If test result still does not meet the requirements, further iteration is needed, and the configuration part of the test vector is updated according to the new group for iterative testing.

In addition, the embodiments of the present disclosure further provide a chip test apparatus. Referring to Fig. 4, Fig. 4 is a schematic structural diagram of a chip test apparatus according to an embodiment of the present disclosure. As shown in Fig. 4, in the embodiment, the chip test apparatus includes: a starting module 100, a configuring module 200, a testing module 300 and an iteration module 400.

The starting module 100 is configured for a main controller to send a test instruction to respective sub-controllers in a memory built-in self-test circuit.

The configuring module 200 is configured for a test control circuit to configure the respective sub-controllers according to a preset group.

The testing module 300 is configured for each sub-controller in the preset group to perform a test according to the test instruction.

The iteration module 400 is configured to, in a case where a test result indicates that the preset group does not comply with a preset standard, re-group the respective sub-controllers based on the test result and perform an iterative test until a test result of the iterative test indicates that a current group complies with the preset standard.

The embodiment provides a chip test apparatus. When an iterative test needs to be performed, it is unnecessary to reconfigure, by the main controller, a MBIST test vector for each sub-controller in the new group determined by the re-grouping, it is only needed to determine, by the test control circuit, which sub-controllers receive the test instruction to perform the iteration test according to the new group. In other words, the MBIST test vector in the embodiments of the present disclosure only needs to be generated once, and as compared with the related art, this saves a lot of time required for repeatedly generating the test vector. In the embodiments of the present disclosure, when an iterative test is performed, the iterative test can be implemented only by configuring, by the test control circuit, the MBIST test vector to corresponding sub-controllers according to the group of the sub-controllers, so that update iteration of the MBIST test vector may be conveniently implemented, and iteration efficiency of the MBIST test vector may be significantly improved.

The chip test apparatus provided by this embodiment and the chip test method provided by the foregoing embodiments belong to the same inventive concept, and for technical details that are not described in detail in this embodiment, reference may be made to any of the foregoing embodiments, and this embodiment has the same beneficial effect as that of executing the chip test method.

The apparatus embodiments described above are merely exemplary, and the units described as separate parts may be or may not be physically separate, may be located in one position, or may be distributed on a plurality of network units. A part or all of the modules may be selected according to actual needs to achieve the objectives of the solutions of the embodiments.

In addition, the embodiments of the present disclosure further provide chip test equipment. The chip test method applied to the chip test equipment may be executed by the chip test apparatus. The chip test apparatus may be implemented by means of software and/or hardware, and is integrated in chip test equipment. The chip test equipment may be a mobile device that is able to communicate with the network side, such as a mobile phone, a notebook computer, or a tablet computer.

Referring to Fig. 5, Fig. 5 is a schematic diagram of the hardware structure of a chip according to an embodiment of the present disclosure. As shown in Fig. 5, the chip test apparatus may include: a processor 1001, such as a Central Processing Unit (CPU), a communication bus 1002, a user interface 1003, a network interface 1004, and a memory 1005. The communications bus 1002 is configured to implement connection and communication between these components. The user interface 1003 may include a display screen and an input unit such as a keyboard. The user interface 1003 may also include a standard wired interface and a standard wireless interface. The network interface 1004 may include a standard wired interface, a Wireless-Fidelity (e.g., a (WI-FI) interface). The memory 1005 may be a high-speed Random Access Memory (RAM) memory, and may also be a stable Non-Volatile Memory (NVM), for example, a magnetic disk memory. The memory 1005 may also be a storage device independent of the foregoing processor 1001.

Those having ordinary skill in the art may understand that the structure shown in Fig. 5 does not limit the chip test equipment, and may include more or fewer components than those shown in the figure, or combine some components, or have different component arrangements. As shown in Fig. 5, the memory 1005 as a storage medium may include an operating system, a data storage module, a network communication module, a user interface module and a computer program.

In the chip test equipment shown in Fig. 5, the network interface 1004 is mainly configured to perform data communication with other devices; the user interface 1003 is mainly configured to perform data interaction with a user; the processor 1001 and the memory 1005 in this embodiment may be set in the chip test equipment, and the chip test equipment invokes, through the processor 1001, the computer program stored in the memory 1005 and executes the chip test method applied to the chip test equipment according to any one of the foregoing embodiments.

The chip test equipment provided in this embodiment and the chip test method applied to the chip test equipment provided in the foregoing embodiment belong to the same inventive concept, and for technical details that are not described in detail in this embodiment, reference may be made to any of the foregoing embodiments, and this embodiment has the same beneficial effect as that of executing the chip test method.

In addition, the embodiments of the present disclosure further provide a computer readable storage medium. The computer readable storage medium may be a non-volatile computer readable storage medium. The computer readable storage medium stores a computer program. When being executed by a processor, the computer program implements the chip test method provided by any of the above embodiments.

Those having ordinary skill in the art may understand that all or some of the operations and systems in the chip test methods disclosed in the foregoing may be implemented as software, firmware, hardware, and a proper combination thereof. Some or all of the physical components may be implemented as software executed by a processor, such as a central processor, digital signal processor, or microprocessor, or as hardware, or as an integrated circuit, such as an application specific integrated circuit. Such software may be distributed on computer readable media, which may include computer storage media (or non-transitory media) and communication media (or transitory media). As is well known to those of ordinary skill in the art, the term computer storage media includes both volatile and nonvolatile, removable and non-removable media implemented in any method or technology for storage of information such as computer readable instructions, data structures, program modules, or other data. Computer storage media includes, but is not limited to, RAM, ROM, EEPROM, flash memory or other memory technology, CD-ROM, digital versatile discs (DVD) or other optical disk storage, magnetic cassettes, magnetic tape, magnetic disk storage or other magnetic storage devices, or any other medium which can be used to store the desired information and which can be accessed by a computer. In addition, communication media typically embodies computer readable instructions, data structures, program modules, or other data in a modulated data signal such as a carrier wave or other transport mechanism and may include any information delivery media as is known to those of ordinary skill in the art.

The foregoing is a detailed description of exemplary implementations of the embodiments of the present disclosure. However, the embodiments of the present disclosure are not limited to the foregoing implementations. Those having ordinary skill in the art may make various equivalent modifications or replacements without departing from the principle of the embodiments of the present disclosure. These equivalent modifications or replacements all fall within the scope defined in the claims of the embodiments of the present disclosure.

## Claims

1. A chip test method, comprising:
sending, by a main controller, a test instruction to respective sub-controllers in a memory built-in self-test circuit;
configuring, by a test control circuit, the respective sub-controllers according to a preset group;
performing, by each sub-controller in the preset group, a test according to the test instruction; and
in a case where a test result indicates that the preset group does not comply with a preset standard, re-grouping the respective sub-controllers based on the test result and performing an iterative test until a test result of the iterative test indicates that a current group complies with the preset standard.

2. The chip test method according to claim 1, wherein before sending, by the main controller, the test instruction to the respective sub-controllers in the memory built-in self-test circuit, the chip test method further comprises:
reading, by the main controller, a preset engineering file; and
performing, by the main controller, configuration according to the engineering file so as to generate a test vector, wherein the test vector comprises the test instruction.

3. The chip test method according to claim 2, wherein performing, by the each sub-controller in the preset group, the test according to the test instruction comprises:
acquiring, by the each sub-controller in the preset group, the test vector according to the test instruction to perform the test.

4. The chip test method according to claim 1, wherein configuring, by the test control circuit, the respective sub-controllers according to the preset group comprises:
shielding, by the test control circuit, the test instruction sent by the main controller towards each sub-controller not belonging to the preset group.

5. The chip test method according to claim 1, wherein at least one set of shielding logic circuit is disposed between the main controller and each of the respective sub-controllers, and configuring, by the test control circuit, the respective sub-controllers according to the preset group comprises:
turning off, by the test control circuit, the shielding logic circuit between the each sub-controller in the preset group and the main controller; and
turning on, by the test control circuit, the shielding logic circuit between each sub-controller not belonging to the preset group and the main controller.

6. The chip test method according to claim 1, wherein after performing, by the each sub-controller in the preset group, the test according to the test instruction, the chip test method further comprises:
acquiring, by the main controller, a test result of the each sub-controller in the preset group;
comparing, by the main controller, the test result with preset data to acquire a comparison result; and
determining, by the main controller, whether the preset group complies with the preset standard according to the comparison result.

7. The chip test method according to any one of claims 1 to 6, wherein re-grouping the respective sub-controllers based on the test result and performing the iterative test comprises:
re-grouping the respective sub-controllers based on the test result;
configuring, by the test control circuit, the respective sub-controllers according to a new group determined by the re-grouping;
performing, by each sub-controller in the new group, the iteration test according to the test instruction.

8. A chip test apparatus, comprising:
a starting module, configured for a main controller to send a test instruction to respective sub-controllers in a memory built-in self-test circuit;
a configuring module, configured for a test control circuit to configure the respective sub-controllers according to a preset group;
a testing module, configured for each sub-controller in the preset group to perform a test according to the test instruction; and
an iteration module, configured to, in a case where a test result indicates that the preset group does not comply with a preset standard, re-group the respective sub-controllers based on the test result and perform an iterative test until a test result of the iterative test indicates that a current group complies with the preset standard.

9. A chip, comprising: a memory, a processor and a computer program stored on the memory and operable on the processor, wherein the computer program, when executed by the processor, implements the chip test method according to any one of claims 1 to 7.

10. A computer readable storage medium, wherein the computer readable storage medium stores a computer program, and the computer program, when being executed by a processor, implements the chip test method according to any one of claims 1 to 7.
